# EUROPEAN PATENT APPLICATION

(11) **EP 0 961 311 A2**
(43) Date of publication of application: **01.12.1999**
(21) Application number: 99110230.2
(22) Date of filing: 26.05.1999
(51) Int. Cl.: H01L 21/02, H01L 21/285

(54) **Capacitor and method for fabricating the same**

(30) Priority: 26.05.1998 JP 14364298
(71) Applicant: MATSUSHITA ELECTRONICS CORPORATION, Takatsuki-shi, Osaka-fu (JP)
(72) Inventor: Tanaka, Keisuke, Otsu-shi, Shiga 520-2145 (JP); Nagano, Yoshihisa, Suita-shi, Osaka 565-0863 (JP); Ito, Toyoji, Kusatsu-shi, Shiga 525-0057 (JP); Mikawa, Takumi, Kyoto-shi, Kyoto 612-8485 (JP)
(74) Representative: Grünecker, Kinkeldey, Stockmair & Schwanhäusser Anwaltssozietät

(57) **Abstract**

A capacitor includes lower electrode, capacitive insulating film, upper electrode and passivation film that are formed in this order on a substrate. The capacitive insulating film is made of an insulating metal oxide, the metal oxide being a ferroelectric or a dielectric with a high relative dielectric constant. At least one contact hole is formed in the passivation film to connect the lower electrode to an interconnect for the lower electrode or the upper electrode to an interconnect for the upper electrode. The opening area of the contact hole is equal to or smaller than 5µm².

## Description

### BACKGROUND OF THE INVENTION

The present invention relates to a capacitor, which can be built in a dynamic RAM, for example, and includes a capacitive insulating film of a ferroelectric or a dielectric with a high relative dielectric constant, and also relates to a method for fabricating the same.

As the digital information processing technologies have been developed by leaps and bounds, it has become more and more necessary these days to process and store a tremendously large quantity of data using devices operating at an even higher speed. Reflecting such tendencies, demand on high-performance electronic units has also been increasing day after day. To implement such a high-performance electronic unit, the number of semiconductor devices, integrated within a single electronic unit, has been remarkably increased and semiconductor components, included within a single semiconductor device, have been drastically downsized recently.

Thus, the number of devices integrated within a single dynamic RAM should also be further increased. To implement such a dynamic RAM, research and development has been carried on worldwide. According to a method recently developed, silicon oxide or silicon nitride, which has been used as a typical material for a capacitive insulating film of a capacitor in a dynamic RAM, is replaced by a ferroelectric or a dielectric with a high relative dielectric constant. Hereinafter, a capacitive insulating film made of a dielectric with a high relative dielectric constant will be simply referred to as a "high-dielectric-constant film".

To implement a nonvolatile RAM that can operate at a lower voltage and can read and write at a higher speed, a ferroelectric film, possessing spontaneous polarization, has also been researched and developed vigorously.

Development of a process, enabling the integration of a capacitor in a CMOS integrated circuit without deteriorating the characteristics thereof, plays a key role in realizing a semiconductor memory device such as a high-performance non-volatile RAM.

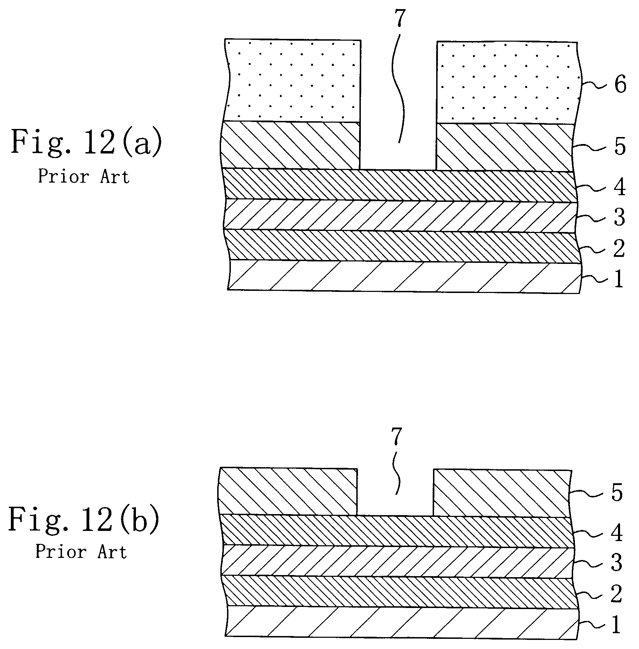

Hereinafter, a conventional method for fabricating a capacitor, including a ferroelectric or high-dielectric-constant film as a capacitive insulating film, will be described with reference to Figures **12(a)** and **12(b)**.

First, as shown in Figure **12(a)**, a lower electrode **2** is formed out of a platinum film on a semiconductor substrate **1**. Then, a capacitive insulating film **3** is formed out of a ferroelectric or high-dielectric-constant film on the lower electrode **2**, and an upper electrode **4** is formed out of a platinum film on the capacitive insulating film **3**. Next, a passivation film **5** is deposited on the upper electrode **4** to cover the electrode **4** entirely. Subsequently, a resist mask **6** with an opening for forming a contact hole is formed on the passivation film **5**. And then the passivation film **5** is dry-etched using the resist mask **6**, thereby forming a contact hole **7** in the passivation film **5** so as to reach the upper electrode **4**. The opening area of the contact hole **7** is 15µm², for example.

Next, as shown in Figure **12(b)**, the resist mask **6** is removed using oxygen radicals, which have been generated by decomposing oxygen gas with microwaves.

In the conventional capacitor and the method for fabricating the same, however, the upper electrode **4** is exposed inside the contact hole **7**. Thus, during the process step of removing the resist mask **6**, insulating metal oxides, included in the ferroelectric or high-dielectric-constant film as the capacitive insulating film **3**, are unintentionally reduced to deteriorate the electrical characteristics of the capacitor.

### SUMMARY OF THE INVENTION

An object of this invention is providing a capacitor with improved electrical characteristics by preventing insulating metal oxides, included in a ferroelectric or high-dielectric-constant film, from being reduced during the process step of removing a resist mask.

The present inventors found that even when a large quantity of hydrogen is released from a resist mask, insulating metal oxides, included in a ferroelectric or high-dielectric-constant film, are hardly reduced by that hydrogen if the opening area of a contact hole, formed in a passivation film, is small.

Also, the present inventors analyzed from various angles the reasons why the insulating metal oxides, included in the ferroelectric or high-dielectric-constant film, are reduced if the resist mask is removed by using oxygen radicals that have been generated by decomposing oxygen gas with microwaves. As a result, we found the following mechanism. Specifically, if oxygen gas is decomposed with microwaves, then the density of electrons, existing in the resulting oxygen plasma, is high. Thus, a large quantity of hydrogen is released from the resist mask. Then, that released hydrogen is activated by the catalytic action of platinum contained in the upper electrode. Consequently, that activated hydrogen diffuses into the ferroelectric or high-dielectric-constant film as the capacitive insulating film to reduce the insulating metal oxides contained in the ferroelectric or high-dielectric-constant film.

Based on this finding, according to a first aspect of the present invention, the opening area of a contact hole, formed in an insulating film covering a capacitor, is defined at a predetermined value or less. According to a second aspect of the present invention, the quantity of hydrogen produced from the resist mask is cut down during the removal thereof, thereby preventing hydrogen from diffusing into the ferroelectric or high-dielectric-constant film as the capacitive insulating film and from reducing the insulating metal oxides contained therein.

A first exemplary capacitor according to the present invention includes a lower electrode, a capacitive insulating film, an upper electrode and a passivation film that are formed in this order on a substrate. The capacitive insulating film is made of an insulating metal oxide, which is a ferroelectric or a dielectric with a high relative dielectric constant. At least one contact hole is formed in the passivation film to connect the lower electrode to an interconnect for the lower electrode or connect the upper electrode to an interconnect for the upper electrode. The opening area of the contact hole is equal to or smaller than 5µm².

A second exemplary capacitor according to the present invention includes a lower electrode, a capacitive insulating film, an upper electrode and a passivation film that are formed in this order on a substrate. The capacitive insulating film is made of an insulating metal oxide, which is a ferroelectric or a dielectric with a high relative dielectric constant. First and second contact holes are formed in the passivation film to connect the lower electrode to an interconnect for the lower electrode and the upper electrode to an interconnect for the upper electrode, respectively. The opening area of each of the first and second contact holes is equal to or smaller than 5µm².

In the first and second capacitors, the opening area of each contact hole is equal to or smaller than 5µm². Accordingly, hydrogen, which is released from the resist mask during the process step of removing the mask to form the contact hole, hardly reaches the capacitive insulating film. That is to say, the insulating metal oxides, included in the ferroelectric or high-dielectric-constant film, are hardly reduced, thus greatly increasing the dielectric breakdown voltage of the capacitive insulating film.

A first exemplary method for fabricating a capacitor according to the present invention includes the steps of: forming a capacitor including a lower electrode, a capacitive insulating film, an upper electrode and a passivation film by using a resist mask; and removing the resist mask. The capacitive insulating film is made of an insulating metal oxide, which is a ferroelectric or a dielectric with a high relative dielectric constant. The step of removing the mask includes removing the resist mask using a resist mask remover.

A second exemplary method for fabricating a capacitor according to the present invention includes the steps of: forming a capacitor including a lower electrode, a capacitive insulating film and an upper electrode by using a resist mask; and removing the resist mask with at least one of the lower and upper electrodes exposed. The capacitive insulating film is made of an insulating metal oxide, which is a ferroelectric or a dielectric with a high relative dielectric constant. The step of removing the mask includes removing the resist mask using a resist mask remover.

In accordance with the first or second method, since the resist mask is removed using a resist mask remover, almost no hydrogen is produced from the resist mask. Thus, it is possible to prevent hydrogen from diffusing into the ferroelectric or high-dielectric-constant film as the capacitive insulating film and from reducing the insulating metal oxide included in the ferroelectric or high-dielectric-constant film. Accordingly, deterioration in electrical characteristics of the capacitor can be prevented with a lot more certainty.

In one embodiment of the first or second method of the present invention, the resist mask remover is preferably a material containing at least one of: an organic solvent; hydrofluoric acid; sulfuric acid; hydrochloric acid; nitric acid; ammonium hydroxide; and deionized hot water.

In such an embodiment, the resist mask can be removed without producing hydrogen from the resist mask.

A third exemplary method for fabricating a capacitor according to the present invention includes the steps of: forming a capacitor including a lower electrode, a capacitive insulating film and an upper electrode by using a resist mask; and removing the resist mask. The capacitive insulating film is made of an insulating metal oxide, which is a ferroelectric or a dielectric with a high relative dielectric constant. The step of removing the mask includes removing the resist mask using oxygen radicals that have been generated by decomposing ozone gas.

Almost no charged particles are included in oxygen radicals generated by decomposing ozone gas. Accordingly, if the resist mask is removed using these oxygen radicals in accordance with the third method, the quantity of hydrogen released from the resist mask decreases.

A fourth exemplary method for fabricating a capacitor according to the present invention includes the steps of: forming a capacitor including a lower electrode, a capacitive insulating film and an upper electrode by using a resist mask; and removing the resist mask. The capacitive insulating film is made of an insulating metal oxide, which is a ferroelectric or a dielectric with a high relative dielectric constant. The step of removing the mask includes removing the resist mask using oxygen radicals that have been generated by decomposing oxygen gas with a plasma. The plasma has been generated in an inductively- or capacitively-coupled plasma processor.

In accordance with the fourth method, since the oxygen radicals are generated by decomposing oxygen gas with a plasma that has been generated in an inductively- or capacitively-coupled plasma processor, almost no charged particles are included in the oxygen radicals. Accordingly, if the resist mask is removed using these oxygen radicals, the quantity of hydrogen released from the resist mask decreases.

A fifth exemplary method for fabricating a capacitor according to the present invention includes the steps of: forming a capacitor including a lower electrode, a capacitive insulating film and an upper electrode by using a resist mask; and removing the resist mask. The capacitive insulating film is made of an insulating metal oxide, which is a ferroelectric or a dielectric with a high relative dielectric constant. The step of removing the mask includes removing the resist mask using oxygen radicals. The oxygen radicals are generated by decomposing oxygen gas with a plasma, which has been generated in a plasma generating chamber, and then are introduced into a plasma processing chamber. The plasma generating chamber and the plasma processing chamber are both included, and separated from each other, in a down-flow plasma processor.

In accordance with the fifth method, oxygen radicals, generated by decomposing oxygen gas with a plasma that has been generated in the plasma generating chamber, are introduced into the plasma processing chamber. Accordingly, only these oxygen radicals with a longer lifetime than that of charged particles are introduced into the plasma processing chamber, and almost no charged particles are included in the oxygen radicals. Thus, if the resist mask is removed using such oxygen radicals, the quantity of hydrogen released from the resist mask decreases.

In accordance with the third through fifth methods of the present invention, almost no charged particles are included in the oxygen radicals used for removing the resist mask, the quantity of hydrogen released from the resist mask decreases. Accordingly, it is possible to prevent hydrogen from diffusing into the ferroelectric or high-dielectric-constant film as the capacitive insulating film and from reducing the insulating metal oxide included in the ferroelectric or high-dielectric-constant film. Thus, deterioration in electrical characteristics of a capacitor can be prevented with a lot more certainty.

### BRIEF DESCRIPTION OF THE DRAWINGS

Figure **1** is a cross-sectional view of a capacitor according to a first embodiment of the present invention.
Figure **2** is a graph illustrating a relationship between the opening area of a contact hole and the dielectric breakdown voltage of a capacitor.
Figures **3(a)** and **3(b)** are cross-sectional views illustrating respective process steps for fabricating a capacitor according to a second embodiment of the present invention.
Figures **4(a)** and **4(b)** are cross-sectional views illustrating respective process steps for fabricating a capacitor according to a third embodiment of the present invention.
Figures **5(a)** and **5(b)** are cross-sectional views illustrating respective process steps for fabricating a capacitor according to a fourth embodiment of the present invention.
Figures **6(a)** and **6(b)** are cross-sectional views illustrating respective process steps for fabricating a capacitor according to a fifth embodiment of the present invention.
Figures **7(a)** and **7(b)** are cross-sectional views illustrating respective process steps for fabricating a capacitor according to a sixth embodiment of the present invention.
Figures **8(a)** and **8(b)** are cross-sectional views illustrating respective process steps for fabricating a capacitor according to a seventh embodiment of the present invention.
Figures **9(a)** and **9(b)** are cross-sectional views illustrating respective process steps for fabricating a capacitor according to an eighth embodiment of the present invention.
Figure **10** is a graph illustrating respective contents of hydrogen in a capacitive insulating film where a resist mask is removed by a conventional method, with a resist mask remover, with oxygen radicals generated from ozone gas, or with oxygen radicals generated in an inductively-coupled or down-flow plasma processor.
Figure **11** is a graph illustrating in comparison the dielectric breakdown voltages of respective capacitors formed by the conventional method and the methods of the present invention.
Figures **12(a)** and **12(b)** are cross-sectional views illustrating respective process steps for fabricating a capacitor according to a conventional method.

### DESCRIPTION OF THE PREFERRED EMBODIMENTS

### EMBODIMENT 1

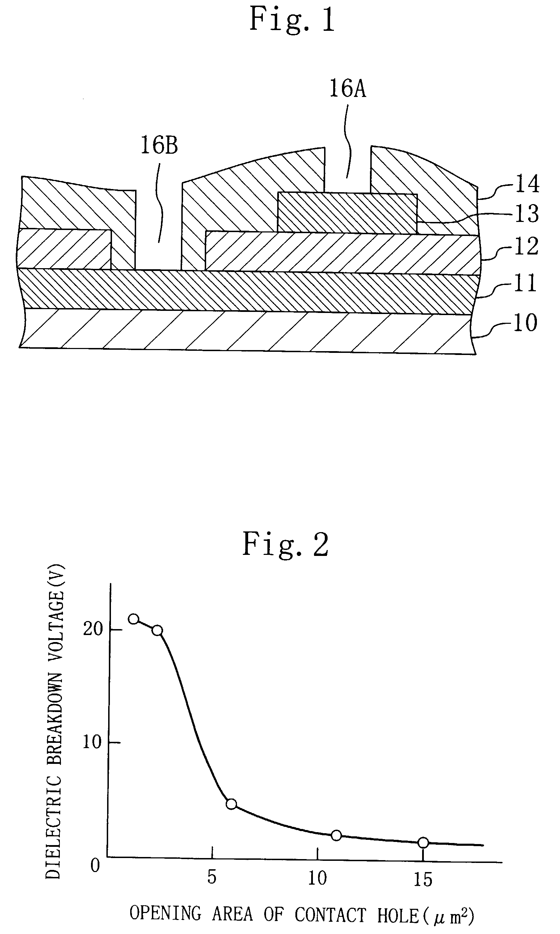

Hereinafter, a capacitor according to a first exemplary embodiment of the present invention will be described with reference to Figure **1**.

As shown in Figure **1**, a capacitor includes lower electrode **11**, capacitive insulating film **12** and upper electrode **13**, which are formed in this order on a semiconductor substrate **10** out of a first platinum film, a ferroelectric or high-dielectric-constant film and a second platinum film, respectively. A passivation film **14** is deposited thereon to cover the capacitor. In the passivation film **14**, first and second contact holes **16A** and **16B** are formed to connect the upper electrode **13** to an interconnect for the upper electrode and the lower electrode **11** to an interconnect for the lower electrode, respectively.

In this embodiment, the opening area of each of the first and second contact holes **16A** and **16B** is defined at 5µm² or less.

Figure **2** illustrates a relationship between the opening area of a contact hole and the dielectric breakdown voltage of a capacitor. As shown in Figure **2**, if the opening area is 5µm² or less, the dielectric breakdown voltage of the capacitor abruptly increases.

Following is believed to be a main reason why the dielectric breakdown voltage of the capacitor abruptly increases when the opening area of the contact hole is defined at 5µm² or less. As described above, in the process step of removing a resist mask using oxygen radicals to form the first and second contact holes **16A** and **16B**, hydrogen is released from the resist mask. However, if the opening area of the resist mask is defined at as small as 5µm² or less, then almost no hydrogen reaches the capacitive insulating film **12**, and the insulating metal oxides, included in the ferroelectric or high-dielectric-constant film, are hardly reduced. Thus, according to the first embodiment, the dielectric breakdown voltage of the capacitor greatly increases.

### EMBODIMENT 2

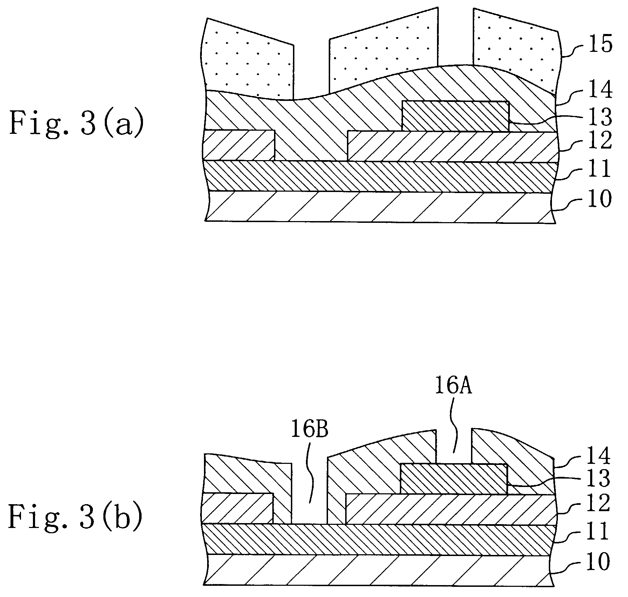

Next, a method for fabricating a capacitor according to a second exemplary embodiment of the present invention will be described with reference to Figures **3(a)** and **3(b)**.

First, as shown in Figure **3(a)**, a lower electrode **11** is formed out of a first platinum film, for example, on a semiconductor substrate **10**. Then, a capacitive insulating film **12** is formed out of a ferroelectric or high-dielectric-constant film on the lower electrode **11**, and an upper electrode **13** is formed out of a second platinum film, for example, on the capacitive insulating film **12**. Next, a passivation film **14** is deposited on the upper electrode **13** to cover the lower electrode **11**, capacitive insulating film **12** and upper electrode **13** entirely.

Subsequently, a mask with openings for forming contact holes, e.g., a resist mask **15**, is formed on the passivation film **14**. Then, the passivation film **14** is dry-etched using the resist mask **15**, thereby forming first and second contact holes **16A** and **16B** to connect the upper electrode **13** to an interconnect for the upper electrode and the lower electrode **11** to an interconnect for the lower electrode, respectively, in the passivation film **14**. As a result, the upper and lower electrodes **13** and **11** are exposed inside the first and second contact holes **16A** and **16B**, respectively.

Next, as shown in Figure **3(b)**, the resist mask **15** is removed using a resist mask remover made of an organic solvent.

In the second embodiment, since the resist mask **15** is removed using a resist mask remover of an organic solvent, almost no hydrogen is produced from the resist mask **15** during the removal of the resist mask **15**. Thus, it is possible to prevent hydrogen from diffusing into the ferroelectric or high-dielectric-constant film as the capacitive insulating film and from reducing the insulating metal oxide included in the ferroelectric or high-dielectric-constant film.

### EMBODIMENT 3

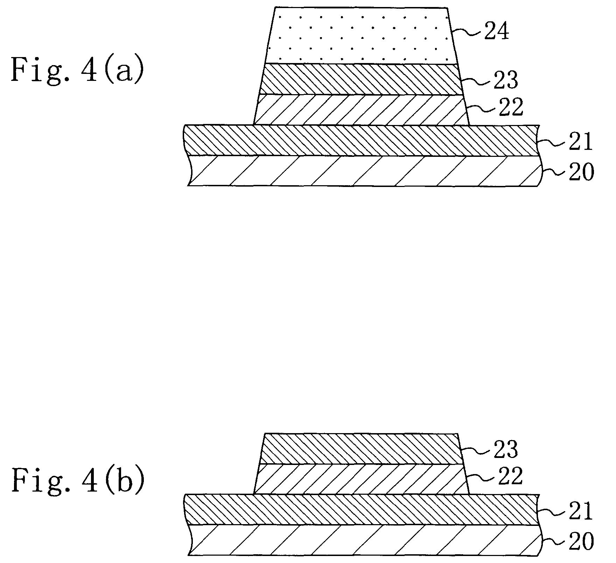

Next, a method for fabricating a capacitor according to a third exemplary embodiment of the present invention will be described with reference to Figures **4(a)** and **4(b)**.

First, as shown in Figure **4(a)**, a lower electrode **21** is formed out of a first platinum film, for example, on a semiconductor substrate **20**. Then, a ferroelectric or high-dielectric-constant film to be a capacitive insulating film **22** is formed on the lower electrode **21**, and a second platinum film to be an upper electrode **23** is deposited thereon. Next, a resist mask **24** is formed on the second platinum film.

Then, the second platinum film and ferroelectric or high-dielectric-constant film are etched in this order using the resist mask **24**, thereby forming the upper electrode **23** and capacitive insulating film **22** out of the second platinum film and ferroelectric or high-dielectric-constant film, respectively.

Next, as shown in Figure **4(b)**, the resist mask **24** is removed using a resist mask remover made of an organic solvent.

In the third embodiment, since the resist mask **24** is removed using a resist mask remover made of an organic solvent, almost no hydrogen is produced from the resist mask **24** during the process step of removing the resist mask **24**. Thus, it is possible to prevent hydrogen from diffusing into the ferroelectric or high-dielectric-constant film as the capacitive insulating film and from reducing the insulating metal oxide included in the ferroelectric or high-dielectric-constant film.

### EMBODIMENT 4

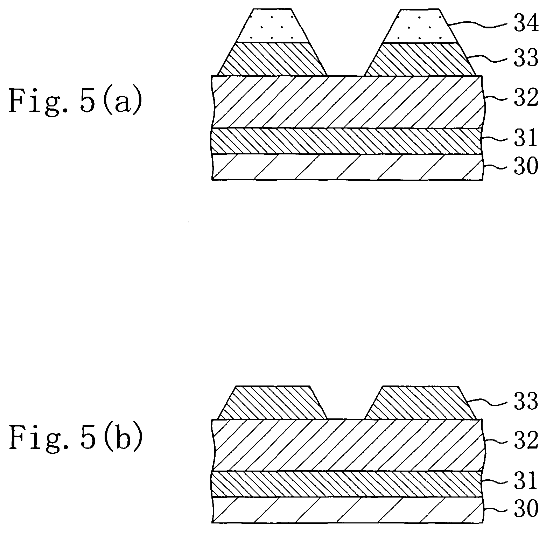

Next, a method for fabricating a capacitor according to a fourth exemplary embodiment of the present invention will be described with reference to Figures **5(a)** and **5(b)**.

First, as shown in Figure **5(a)**, a lower electrode **31** is formed out of a first platinum film, for example, on a semiconductor substrate **30**. Then, a ferroelectric or high-dielectric-constant film to be a capacitive insulating film **32** is formed on the lower electrode **31**, and a second platinum film to be an upper electrode **33** is deposited thereon. Next, a resist mask **34** is formed on the second platinum film.

Then, the second platinum film is etched using the resist mask **34**, thereby forming the upper electrode **33** out of the second platinum film.

Next, as shown in Figure **5(b)**, the resist mask **34** is removed using a resist mask remover made of an organic solvent.

In the fourth embodiment, since the resist mask **34** is removed using a resist mask remover made of an organic solvent, almost no hydrogen is produced from the resist mask **34** during the process step of removing the resist mask **34**. Thus, it is possible to prevent hydrogen from diffusing into the ferroelectric or high-dielectric-constant film as the capacitive insulating film and from reducing the insulating metal oxide included in the ferroelectric or high-dielectric-constant film.

### EMBODIMENT 5

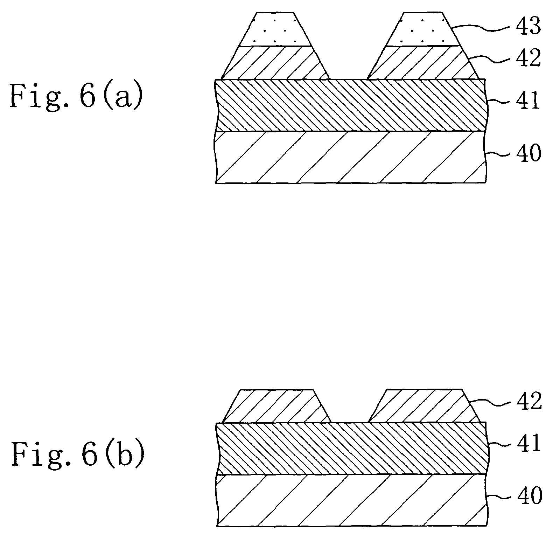

Next, a method for fabricating a capacitor according to a fifth exemplary embodiment of the present invention will be described with reference to Figures **6(a)** and **6(b)**.

First, as shown in Figure **6(a)**, a lower electrode **41** is formed out of a first platinum film, for example, on a semiconductor substrate **40**. Then, a ferroelectric or high-dielectric-constant film to be a capacitive insulating film **42** is deposited on the lower electrode **41**. Next, a resist mask **43** is formed on the ferroelectric or high-dielectric-constant film.

Then, the ferroelectric or high-dielectric-constant film is etched using the resist mask **43**, thereby forming the capacitive insulating film **42**.

Next, as shown in Figure **6(b)**, the resist mask **43** is removed using a resist mask remover made of an organic solvent.

In the fifth embodiment, since the resist mask **43** is removed using a resist mask remover made of an organic solvent, almost no hydrogen is produced from the resist mask **43** during the process step of removing the resist mask **43**. Thus, it is possible to prevent hydrogen from diffusing into the ferroelectric or high-dielectric-constant film as the capacitive insulating film and from reducing the insulating metal oxide included in the ferroelectric or high-dielectric-constant film.

### EMBODIMENT 6

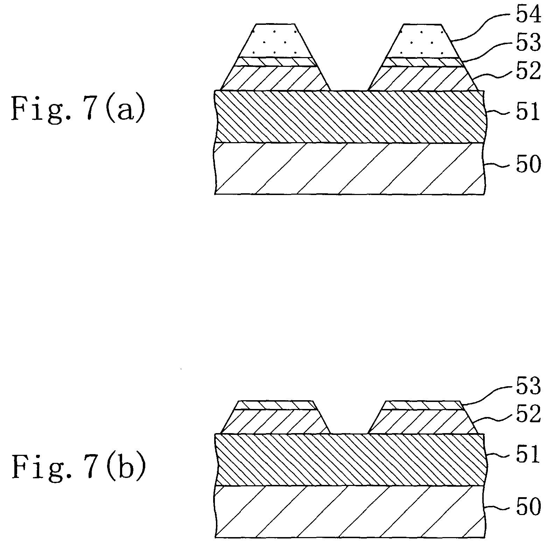

Next, a method for fabricating a capacitor according to a sixth exemplary embodiment of the present invention will be described with reference to Figures **7(a)** and **7(b)**.

First, as shown in Figure **7(a)**, a lower electrode **51** is formed out of a first platinum film, for example, on a semiconductor substrate **50**. Then, a ferroelectric or high-dielectric-constant film to be a capacitive insulating film **52** is formed on the lower electrode **51**, and a silicon oxide film to be a passivation film **53** is deposited thereon. Next, a resist mask **54** is formed on the silicon oxide film.

Then, the silicon oxide film and the ferroelectric or high-dielectric-constant film are etched in this order using the resist mask **54**, thereby forming the passivation film **53** and the capacitive insulating film **52**, respectively.

Next, as shown in Figure **7(b)**, the resist mask **54** is removed using a resist mask remover made of an organic solvent.

In the sixth embodiment, since the resist mask **54** is removed using a resist mask remover made of an organic solvent, almost no hydrogen is produced from the resist mask **54** during the process step of removing the resist mask **54**. Thus, it is possible to prevent hydrogen from diffusing into the ferroelectric or high-dielectric-constant film as the capacitive insulating film and from reducing the insulating metal oxide included in the ferroelectric or high-dielectric-constant film.

### EMBODIMENT 7

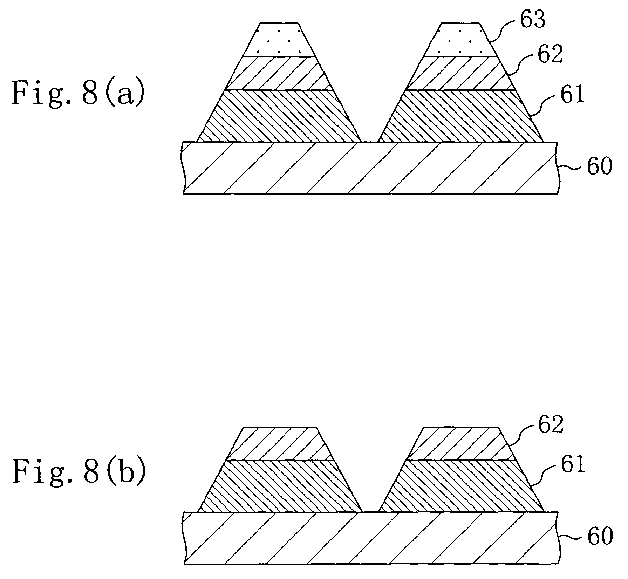

Next, a method for fabricating a capacitor according to a seventh exemplary embodiment of the present invention will be described with reference to Figures **8(a)** and **8(b)**.

First, as shown in Figure **8(a)**, a platinum film to be a lower electrode **61** and a ferroelectric or high-dielectric-constant film to be a capacitive insulating film **62** are deposited in this order on a semiconductor substrate **60**. Next, a resist mask **63** is formed on the ferroelectric or high-dielectric-constant film.

Then, the ferroelectric or high-dielectric-constant film and the platinum film are etched in this order using the resist mask **63**, thereby forming the capacitive insulating film **62** and the lower electrode **61**.

Next, as shown in Figure **8(b)**, the resist mask **63** is removed using a resist mask remover made of an organic solvent.

In the seventh embodiment, since the resist mask **63** is removed using a resist mask remover made of an organic solvent, almost no hydrogen is produced from the resist mask **63** during the process step of removing the resist mask **63**. Thus, it is possible to prevent hydrogen from diffusing into the ferroelectric or high-dielectric-constant film as the capacitive insulating film and from reducing the insulating metal oxide included in the ferroelectric or high-dielectric-constant film.

### EMBODIMENT 8

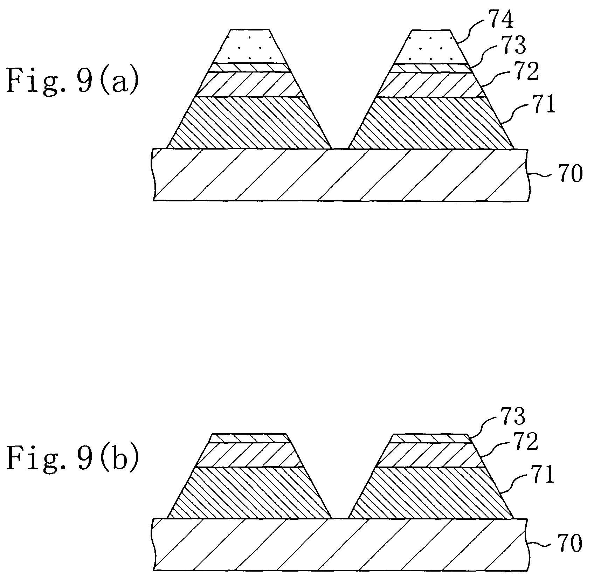

Next, a method for fabricating a capacitor according to an eighth exemplary embodiment of the present invention will be described with reference to Figures **9(a)** and **9(b)**.

First, as shown in Figure **9(a)**, platinum film to be a lower electrode **71**, ferroelectric or high-dielectric-constant film to be a capacitive insulating film **72** and silicon oxide film to be a passivation film **73** are deposited in this order on a semiconductor substrate **70**. Next, a resist mask **74** is formed on the silicon oxide film.

Then, the silicon oxide film, ferroelectric or high-dielectric-constant film and platinum film are etched in this order using the resist mask **74**, thereby forming the passivation film **73**, capacitive insulating film **72** and the lower electrode **71**, respectively.

Next, as shown in Figure **9(b)**, the resist mask **74** is removed using a resist mask remover made of an organic solvent.

In the eighth embodiment, since the resist mask **74** is removed using a resist mask remover made of an organic solvent, almost no hydrogen is produced from the resist mask **74** during the process step of removing the resist mask **74**. Thus, it is possible to prevent hydrogen from diffusing into the ferroelectric or high-dielectric-constant film as the capacitive insulating film and from reducing the insulating metal oxide included in the ferroelectric or high-dielectric-constant film.

In the foregoing second through eighth embodiments, the resist mask is removed using a resist mask remover made of an organic solvent. Alternatively, the resist mask may be removed using a solvent containing at least one of: hydrofluoric acid; sulfuric acid; hydrochloric acid; nitric acid; ammonium hydroxide; and deionized hot water.

### EMBODIMENT 9

Next, a method for fabricating a capacitor according to a ninth exemplary embodiment of the present invention will be described. The method of the ninth embodiment is different from the methods of the second through eighth embodiments only in the process step of removing the resist mask. Thus, only this mask removing process step will be described.

First, ozone gas is decomposed by heating the ozone gas or by irradiating far infrared radiation to the ozone gas with or without heating the gas, thereby generating oxygen radicals without generating charged particles. The oxygen radicals generated are introduced onto the resist mask to cause a chemical reaction between the resist mask and the oxygen radicals and thereby decompose the resist mask into CO₂ and H₂O. Finally, CO₂ and H₂O are removed.

The process of generating oxygen radicals by heating the ozone gas may be carried out under the conditions that the quantity of ozone introduced is 4.5 liters per minute and the temperature is 300°C, for example.

In the ninth embodiment, oxygen radicals are generated by decomposing ozone gas, and therefore almost no charged particles exist in the resulting oxygen radicals. Thus, if the resist mask is decomposed using such oxygen radicals, the quantity of hydrogen released from the resist mask decreases. Accordingly, it is possible to prevent hydrogen from diffusing into the ferroelectric or high-dielectric-constant film as the capacitive insulating film and from reducing the insulating metal oxide included in the ferroelectric or high-dielectric-constant film.

### EMBODIMENT 10

Next, a method for fabricating a capacitor according to a tenth exemplary embodiment of the present invention will be described, The method of the tenth embodiment is also different from the methods of the second through eighth embodiments only in the process step of removing the resist mask. Thus, only this mask removing process step will be described.

First, oxygen gas is introduced into the chamber of an inductively- or capacitively-coupled plasma processor, while at the same time a plasma is generated between counter electrodes or coaxial electrodes inside the chamber. In this manner, the oxygen gas is decomposed with the plasma, thereby generating oxygen radicals. The oxygen radicals generated are introduced onto the semiconductor substrate placed on a stage within the chamber to cause a chemical reaction between the resist mask and the oxygen radicals and thereby decompose the resist mask into CO₂ and H₂O. Finally, CO₂ and H₂O are removed.

This process is preferably carried out under the conditions that pressure inside the chamber is 0.5 Torr to 1 Torr, flow rate of the oxygen gas is 200 sccm to 500 sccm, radio frequency power applied to the counter or coaxial electrodes is 400 W to 1000 W at 13.56 MHz and temperature at the stage is 100°C to 200°C, The optimum processing conditions include: in-chamber pressure of 0.5 Torr; O₂ flow rate of 400 sccm; radio frequency power of 800 W at 13.56 MHz; and stage temperature of 150°C.

In the tenth embodiment, oxygen radicals are generated by decomposing oxygen gas with a plasma that has been generated in an inductively- or capacitively-coupled plasma processor, and therefore almost no charged particles exist in the resulting oxygen radicals. Thus, if the resist mask is decomposed using such oxygen radicals, the quantity of hydrogen released from the resist mask decreases. Accordingly, it is possible to prevent hydrogen from diffusing into the ferroelectric or high-dielectric-constant film as the capacitive insulating film and from reducing the insulating metal oxide included in the ferroelectric or high-dielectric-constant film.

### EMBODIMENT 11

Next, a method for fabricating a capacitor according to an eleventh exemplary embodiment of the present invention will be described. The method of the eleventh embodiment is also different from the methods of the second through eighth embodiments only in the process step of removing the resist mask. Thus, only this mask removing process step will be described.

In the eleventh embodiment, a down-flow plasma processor (also called a "downstream plasma processor") is used. In the down-flow plasma processor, a plasma generating chamber for generating oxygen radicals and a plasma processing chamber for resist removal are separately provided. First, oxygen gas is decomposed with a plasma generated in the plasma generating chamber, thereby generating oxygen radicals. Then, only oxygen radicals with a longer lifetime than that of charged particles are introduced into the plasma processing chamber in accordance with a down-flow technique. In the plasma processing chamber, the oxygen radicals introduced are supplied onto the semiconductor substrate placed on a stage within the chamber to cause a chemical reaction between the resist mask and the oxygen radicals. As a result, the resist mask is decomposed into CO₂ and H₂O, which are ultimately removed.

This process is preferably carried out under similar conditions to those adopted in the tenth embodiment, namely, pressure inside the chamber is 0.5 Torr to 1 Torr, flow rate of the oxygen gas is 200 sccm to 500 sccm, radio frequency power applied to the electrodes is 400 W to 1000 W at 13.56 MHz and temperature at the stage is 100°C to 200°C. The optimum processing conditions include: in-chamber pressure of 0.5 Torr; O₂ flow rate of 400 sccm; radio frequency power of 800 w at 13.56 MHz; and stage temperature of 150°C.

In the eleventh embodiment, oxygen radicals, generated by decomposing oxygen gas with a plasma that has been generated in the plasma generating chamber, are introduced into the plasma processing chamber. That is to say, since only oxygen radicals with a longer lifetime than that of charged particles are introduced into the plasma processing chamber, almost no charged particles exist in the resulting oxygen radicals. Thus, if the resist mask is decomposed using such oxygen radicals, the quantity of hydrogen released from the resist mask decreases. Accordingly, it is possible to prevent hydrogen from diffusing into the ferroelectric or high-dielectric-constant film as the capacitive insulating film and from reducing the insulating metal oxide included in the ferroelectric or high-dielectric-constant film.

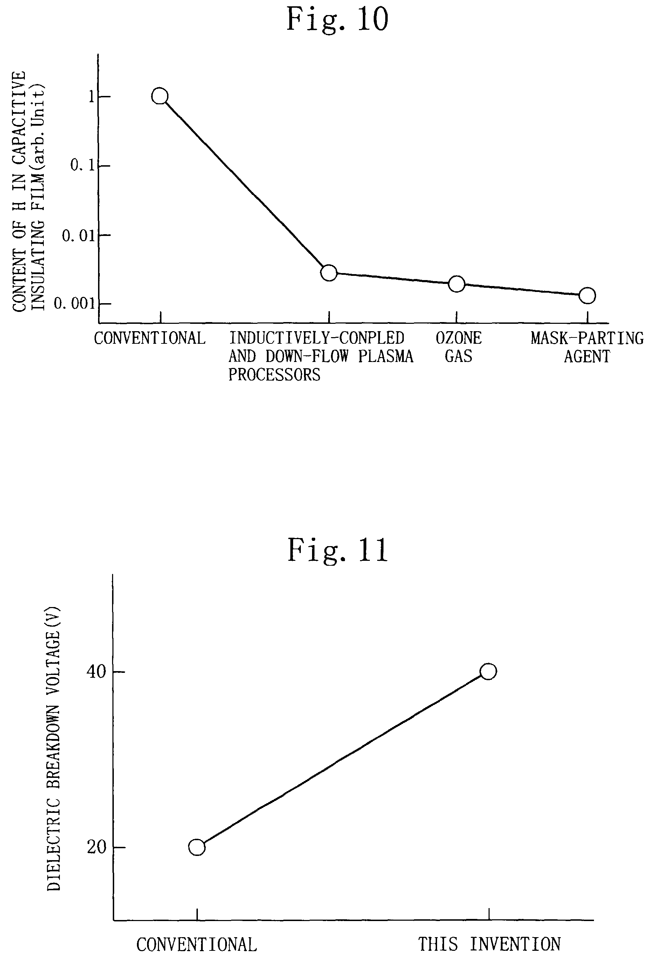

Next, results of tests performed to evaluate the respective methods for fabricating a capacitor according to the second through eleventh embodiments will be briefly described with reference to Figures **10** and **11**.

Figure **10** illustrates respective contents of hydrogen (by an arbitrary unit) in a capacitive insulating film where a mask pattern is removed by a conventional method, with a resist mask remover (Embodiments 2 through 8), with oxygen radicals generated from ozone gas (Embodiment 9), with oxygen radicals generated in an inductively-coupled plasma processor (Embodiment 10) or with oxygen radicals generated in a down-flow plasma processor (Embodiment 11). As can be understood from Figure **10**, according to the methods of the second through eleventh embodiments, the contents of hydrogen in the capacitive insulating film are much smaller than the content resulting from the conventional method.

Figure **11** illustrates in comparison the dielectric breakdown voltages of respective capacitors formed by the conventional method and the methods of the present invention. As can be understood from Figure **11**, the dielectric breakdown voltage of the capacitors formed by the methods of the present invention is 40 V, which is much higher than that of the capacitor formed by the conventional method (20 V).

## Claims

1. A capacitor comprising a lower electrode, a capacitive insulating film, an upper electrode and a passivation film that are formed in this order on a substrate, the capacitive insulating film being made of an insulating metal oxide, the metal oxide being a ferroelectric or a dielectric with a high relative dielectric constant,
wherein at least one contact hole is formed in the passivation film to connect the lower electrode to an interconnect for the lower electrode or connect the upper electrode to an interconnect for the upper electrode, and
wherein the opening area of the contact hole is equal to or smaller than 5µm².

2. A capacitor comprising a lower electrode, a capacitive insulating film, an upper electrode and a passivation film that are formed in this order on a substrate, the capacitive insulating film being made of an insulating metal oxide, the metal oxide being a ferroelectric or a dielectric with a high relative dielectric constant,
wherein first and second contact holes are formed in the passivation film to connect the lower electrode to an interconnect for the lower electrode and the upper electrode to an interconnect for the upper electrode, respectively, and
wherein the opening area of each of the first and second contact holes is equal to or smaller than 5µm².

3. A method for fabricating a capacitor, comprising the steps of:
forming a capacitor including a lower electrode, a capacitive insulating film, an upper electrode and a passivation film by using a resist mask, the capacitive insulating film being made of an insulating metal oxide, the metal oxide being a ferroelectric or a dielectric with a high relative dielectric constant; and
removing the resist mask,
wherein the step of removing the mask includes removing the resist mask using a resist mask remover.

4. The method of Claim 3, wherein the resist mask remover is a material containing at least one of: an organic solvent; hydrofluoric acid; sulfuric acid; hydrochloric acid; nitric acid; ammonium hydroxide; and deionized hot water.

5. A method for fabricating a capacitor, comprising the steps of:
forming a capacitor including a lower electrode, a capacitive insulating film and an upper electrode by using a resist mask, the capacitive insulating film being made of an insulating metal oxide, the metal oxide being a ferroelectric or a dielectric with a high relative dielectric constant; and
removing the resist mask with at least one of the lower and upper electrodes exposed,
wherein the step of removing the mask includes removing the resist mask using a resist mask remover.

6. The method of Claim 5, wherein the resist mask remover is a material containing at least one of: an organic solvent; hydrofluoric acid; sulfuric acid; hydrochloric acid; nitric acid; ammonium hydroxide; and deionized hot water.

7. A method for fabricating a capacitor, comprising the steps of:
forming a capacitor including a lower electrode, a capacitive insulating film and an upper electrode by using a resist mask, the capacitive insulating film being made of an insulating metal oxide, the metal oxide being a ferroelectric or a dielectric with a high relative dielectric constant; and
removing the resist mask,
wherein the step of removing the mask includes removing the resist mask using oxygen radicals that have been generated by decomposing ozone gas.

8. A method for fabricating a capacitor, comprising the steps of:
forming a capacitor including a lower electrode, a capacitive insulating film and an upper electrode by using a resist mask, the capacitive insulating film being made of an insulating metal oxide, the metal oxide being a ferroelectric or a dielectric with a high relative dielectric constant; and
removing the resist mask,
wherein the step of removing the mask includes removing the resist mask using oxygen radicals that have been generated by decomposing oxygen gas with a plasma, the plasma having been generated in an inductively-coupled plasma processor or a capacitively-coupled plasma processor.

9. A method for fabricating a capacitor, comprising the steps of:
forming a capacitor including a lower electrode, a capacitive insulating film and an upper electrode by using a resist mask, the capacitive insulating film being made of an insulating metal oxide, the metal oxide being a ferroelectric or a dielectric with a high relative dielectric constant; and
removing the resist mask,
wherein the step of removing the mask includes removing the resist mask using oxygen radicals, the oxygen radicals being generated by decomposing oxygen gas with a plasma, which has been generated in a plasma generating chamber, and then introduced into a plasma processing chamber, the plasma generating chamber and the plasma processing chamber being both included, and separated from each other, in a down-flow plasma processor.
